# FASCICULE DE BREVET EUROPEEN

(11) **EP 1 425 592 B1**
(45) Date de publication et mention de la délivrance du brevet: **28.04.2010**
(21) Numéro de dépôt: 02785486.8
(22) Date de dépôt: 04.09.2002
(51) Int. Cl.: G01R 19/155, G01R 15/22

(54) **DISPOSITIF INDICATEUR DE PRESENCE TENSION ET APPAREIL ELECTRIQUE COMPORTANT UN TEL INDICATEUR**
SPANNUNGSANZEIGER UND DAMIT VERSEHENES ELEKTRISCHES GERÄT
DEVICE INDICATING VOLTAGE PRESENCE AND ELECTRICAL APPLIANCE COMPRISING THE SAME

(30) Priorité: 14.09.2001 FR 0111940
(43) Date de publication de la demande: 09.06.2004
(73) Titulaire: Schneider Electric Industries SAS, 92500 Rueil-Malmaison (FR)
(72) Inventeur: BARRAULT, Michel, F-38710 Mens (FR); MINIER, Vincent, F-38640 Claix (FR); ARNAUD, Agnès, F-38100 Grenoble (FR)
(74) Mandataire: Tripodi, Paul
(86) Numéro de dépôt international: PCT/FR2002/003005
(87) Numéro de publication internationale: WO 2003/025591

(56) Documents cités:
- EP-A- 0 109 914
- US-A- 3 002 121
- US-A- 3 039 013
- US-A- 5 051 733

## Description

### DOMAINE TECHNIQUE

L'invention concerne un dispositif indicateur de présence tension comportant :
- une électrode collectrice destinée à avoir au moins une liaison capacitive avec une masse électrique ou une liaison capacitive avec un conducteur électrique à surveiller, et
- des moyens de visualisation connectés à ladite électrode collectrice pour indiquer la présence d'une tension électrique dans ledit conducteur électrique à surveiller.

L'invention concerne aussi un appareil électrique comportant un conducteur électrique et un tel dispositif indicateur de présence tension.

### ÉTAT DE LA TECHNIQUE

Il existe des dispositifs indicateurs de présence tension utilisant divers moyens de visualisation pour indiquer la présence d'une tension électrique. Certains sont basés sur l'utilisation d'une lampe au néon ou d'un tube à décharge connectés à un diviseur capacitif formé par des électrodes flottantes ou des composants électriques. De tels dispositifs sont décrits dans les brevets US3991367, US4251770, et dans les demandes de brevets FR2689248 et EP0109914. Ces dispositifs à lampes ont l'inconvénient d'une durée de vie limitée. Généralement, la durée de vie est inférieure à 50000 heures.

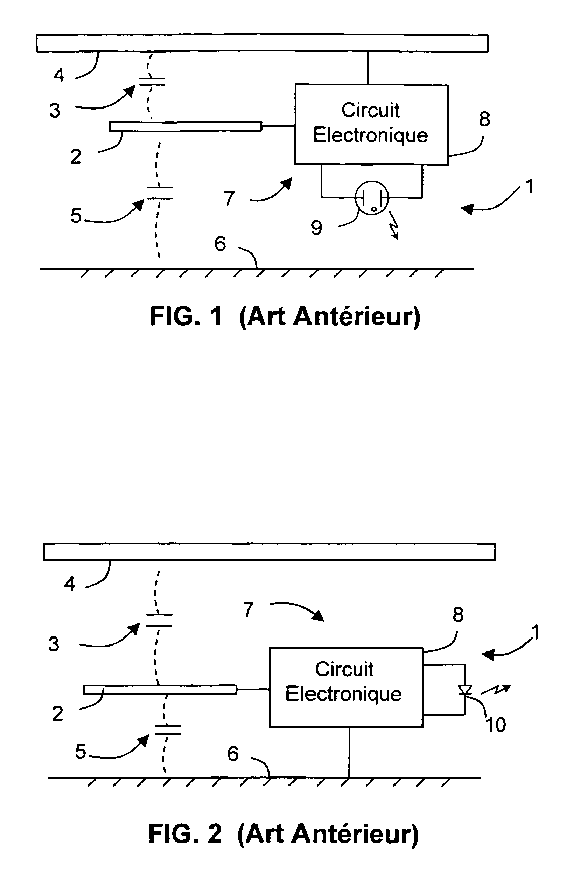

Un schéma d'un dispositif à lampe au néon est représenté sur la figure 1. Sur ce schéma, un dispositif 1 indicateur de présence tension comporte une électrode collectrice 2 ayant une première liaison capacitive 3 avec un conducteur 4 à surveiller et une seconde liaison capacitive 5 avec une masse électrique 6. L'électrode 2 est connectée à des moyens de visualisation 7 comportant un circuit électronique 8 pour commander l'éclairage d'un voyant au néon 9 lorsqu'une tension électrique est présente sur le conducteur électrique 4. Dans ce cas, par exemple, le circuit électronique est relié au potentiel du conducteur 4.

D'autres dispositifs à diodes électroluminescentes (LED) ont une durée de vie plus importante. Un dispositif de ce type est décrit dans le brevet EP0402277B1. Dans ce dispositif, il est nécessaire de disposer d'un circuit électronique complexe pour redresser le courant et commander la diode avec un seuil prédéterminé. De plus, le courant de fonctionnement étant élevé, les électrodes flottantes ou les condensateurs du diviseur capacitif ont des dimensions importantes.

Un schéma d'un dispositif à diode électroluminescente est représenté sur la figure 2. Sur ce schéma, l'électrode 2 est connectée au circuit électronique 8 pour commander l'éclairage d'une diode électroluminescente 10 lorsqu'une tension électrique est présente sur le conducteur électrique 4. Dans ce cas, par exemple, le circuit électronique est relié au potentiel de la masse électrique 6.

Dans d'autres dispositifs, les moyens de visualisations sont des voyants à cristaux liquides. De tels dispositifs sont décrits dans les brevets US5274324, US5070201, US5077520. Ces dispositifs ont besoin de peu d'énergie électrique fournie par le diviseur capacitif, cependant ils ont le défaut de ne pas rayonner ou émettre de lumière. Ainsi, pour visualiser avec de tels dispositifs, il est nécessaire d'avoir une source lumineuse auxiliaire qui éclaire les cristaux liquides soit par l'avant en réflexion soit par l'arrière avec une lumière traversant les cristaux. Un autre inconvénient des cristaux liquides concerne leur tenue en température généralement peu élevée.

US 505 051 733 décrit un dispositif indicateur de présence haute tension.

Les dispositifs de l'état de la technique fonctionnent généralement en haute tension ou en moyenne tension. Lorsqu'ils sont en moyenne tension l'électrode flottante ou collectrice doit être de taille très importante pour fournir suffisamment d'énergie au dispositif de visualisation. Certains dispositifs utilisent des composants tels que des condensateurs disposés dans des isolateurs pour réaliser la fonction de diviseur capacitif. De plus, dans la plupart des dispositifs un circuit électronique est nécessaire pour adapter la tension fournie par le diviseur capacitif aux moyens de visualisation. Ainsi, le coût des dispositifs d'indication de présence tension de l'état de la technique est très élevé. Ce coût élevé est très sensible pour des cellules en moyenne tension. D'autres problèmes sont particulièrement présents en moyenne tension, notamment le volume occupé par les dispositifs indicateurs de présence tension connus qui risque d'être incompatible avec les dimensions réduites des cellules.

### EXPOSE DE L'INVENTION

L'invention a pour but un dispositif indicateur de présence tension, défini par la revendication 1, ayant un faible coût, une bonne tenue en température et une durée de vie élevée.

Dans un dispositif selon l'invention les moyens de visualisation comportent au moins un dispositif multicouche comportant :
- une couche électroluminescente disposée entre une première et une seconde couches isolantes,
- une première couche conductrice disposée sur la première couche isolante et reliée à ladite électrode conductrice, et
- une seconde couche conductrice disposée sur la seconde couche isolante.

Dans un mode de réalisation préférentiel, au moins ladite première couche conductrice ou ladite seconde couche conductrice a au moins une partie transparente ou translucide.

De préférence, ladite couche électroluminescente est réalisée en couche mince d'épaisseur inférieure à 2 µm.

Selon une variante, ladite couche électroluminescente est réalisée en couche déposée sous forme de poudre.

Avantageusement, au moins ladite première couche conductrice ou ladite seconde couche conductrice a une partie transparente et une partie opaque.

Dans un mode de réalisation particulier, au moins ladite première couche conductrice ou ladite seconde couche conductrice comporte une face réfléchissante dirigée vers la couche électroluminescente.

Avantageusement, l'électrode collectrice et ladite première couche conductrice forment un même élément.

De préférence, les couches conductrices, isolantes, et électroluminescente sont disposées sur un substrat en verre et protégées par un recouvrement protecteur.

De préférence, l'électrode collectrice à une forme sensiblement cylindrique disposée autour du conducteur électrique à surveiller.

Selon une variante, le dispositif multicouche est disposé sur le conducteur à surveiller, la seconde couche conductrice étant en contact avec ledit conducteur.

De préférence, l'électrode électroluminescente a une surface inférieure à 1 cm² et l'électrode collectrice à une surface comprise entre 100 et 1000 cm².

Avantageusement, l'électrode collectrice est formée par une coupelle de protection d'un conducteur d'un appareil haute ou moyenne tension, les moyens de visualisation étant disposés à proximité ou sur ladite coupelle de protection.

Un appareil électrique selon l'invention et comme défini par la revendication 13 comporte au moins un conducteur électrique et un dispositif indicateur de présence tension tel que défini ci-dessus pour indiquer la présence de tension électrique sur ledit au moins un conducteur électrique.

Dans un mode particulier de réalisation, l'appareil électrique est constitué par une cellule moyenne tension ou haute tension.

De préférence, la forme de l'électrode collectrice et sa distance par rapport audit conducteur électrique ou la masse électrique permet l'éclairage de la couche luminescente à partir d'une tension électrique, entre ledit conducteur électrique et ladite masse, supérieure à 3000 V.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- les figures 1 et 2 représentent des schémas de dispositifs indicateurs de présence tension de l'art antérieur ;
- les figures 3, 4 et 5 représentent des modes de réalisation d'un dispositif selon l'invention ;
- les figures 6 et 7 représentent des dispositions d'un dispositif selon des modes de réalisation de l'invention ;
- la figure 8 représente un mode de réalisation d'un dispositif selon l'invention associé à des conduits optiques ;
- les figures 9, 10 et 11 représentent un dispositif selon un mode de réalisation de l'invention dans un appareil électrique ;
- la figure 12 représente une courbe de luminescence d'un dispositif selon l'invention en fonction d'une tension électrique entre des couches conductrices;
- la figure 13 représente une courbe de luminescence d'une couche électroluminescence en fonction d'une tension électrique alternative entre des couches conductrices;
- la figure 14 représente une modélisation électrique d'un dispositif selon un mode de réalisation de l'invention.

Sur certaines figures, les proportions entre les différents éléments ne sont par respectées pour faciliter la compréhension des dessins.

### DESCRIPTION DETAILLEE DE MODES DE REALISATION PREFERES

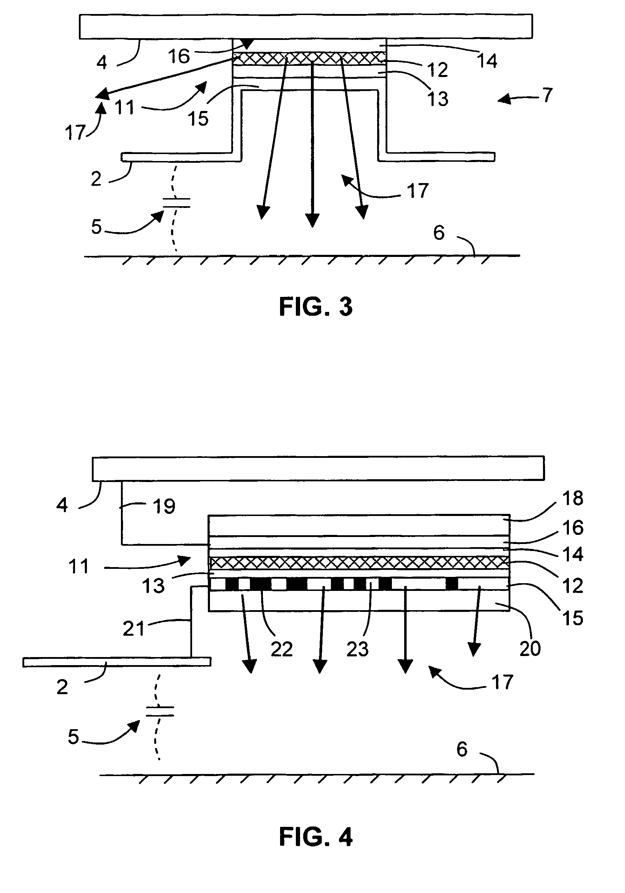

Dans le dispositif représenté sur la figure 3 les moyens de visualisation 7 comportent un dispositif multicouche électroluminescent 11. Ce dispositif lumineux comporte une couche électroluminescente 12 disposée entre une première couche isolante 13 et une seconde couche isolante 14. Une première couche conductrice 15 disposée sur la première couche isolante est reliée à l'électrode conductrice 2. La couche 15 et l'électrode 2 peuvent former un même élément comme sur le dessin de la figure 3. Dans ce mode réalisation, une couche conductrice 16 est disposée sur la seconde couche isolante. Cette couche 16 est reliée au conducteur 4, elle peut aussi être formée par une partie du conducteur lui-même. La couche 15 a au moins une partie translucide pour laisser passer une lumière 17 émise par la couche électroluminescente. Le rayonnement 17 peut aussi être émis par la tranche du dispositif 11 dans le prolongement de la couche électroluminescente.

Lorsqu'une tension électrique augmente entre le conducteur 4 et la masse 6, l'électrode 2 en liaison capacitive 5 avec la masse fournie des charges électriques à l'électrode 15. Ainsi, un champ électrique se forme entre les deux électrodes conductrices 15 et 16, et dans la couche 12 en matériau électroluminescent. Si le champ électrique devient suffisamment élevé, la couche électroluminescente émet une lumière 17. Sur la figure 3, la lumière traverse la couche isolante 13 et des parties translucides de la couche conductrice 15.

Selon la technologie utilisée, la couche électroluminescente est réalisée sous forme de couche mince ou sous forme d'un dépôt de poudre de matériau luminescent.

Avantageusement, un mode de réalisation sous forme de couche mince fournit une durée de vie très élevée supérieure à 100000 heures, un très bon contraste, et une bonne tenue en température. De préférence la couche électroluminescente a une épaisseur inférieure à 2 µm (micromètres), avantageusement entre 0,1 et 1 µm. Pour augmenter le champ électrique, et l'effet lumineux de la couche fluorescente, les couches isolantes sont de préférence de très faibles épaisseurs et ont une constante diélectrique élevée. Avantageusement, l'épaisseur des couches isolantes est inférieure à 1 µm, par exemple entre 300 et 500 nm (nanomètres). Avec des telles dimensions le champ électrique appliqué est très élevé. Par exemple la couche électroluminescente est réalisée avec un matériau de formule ZnS-Mn selon un dosage approprié.

Un dispositif selon un mode de réalisation de l'invention comportant un dispositif multicouche en couches minces est représenté sur la figure 4. Sur cette figure, le dispositif multicouches 11 comporte respectivement un substrat 18 généralement en verre, une couche 16 conductrice connectée à travers un conducteur 19 au conducteur 4, une couche isolante 14, une couche 12 électroluminescente, une couche isolante 13, une couche 15 conductrice connectée à l'électrode 2 par un conducteur 21, et une couche 20 de protection généralement en verre. La couche 15 a des parties opaques 22 pour arrêter la lumière et des parties translucides 23 pour laisser passer des rayons lumineux 17 émis par la couche électroluminescente. Les couches conductrices permettent avantageusement d'avoir un champ électrique sensiblement uniforme sur la surface utile de la couche électroluminescente.

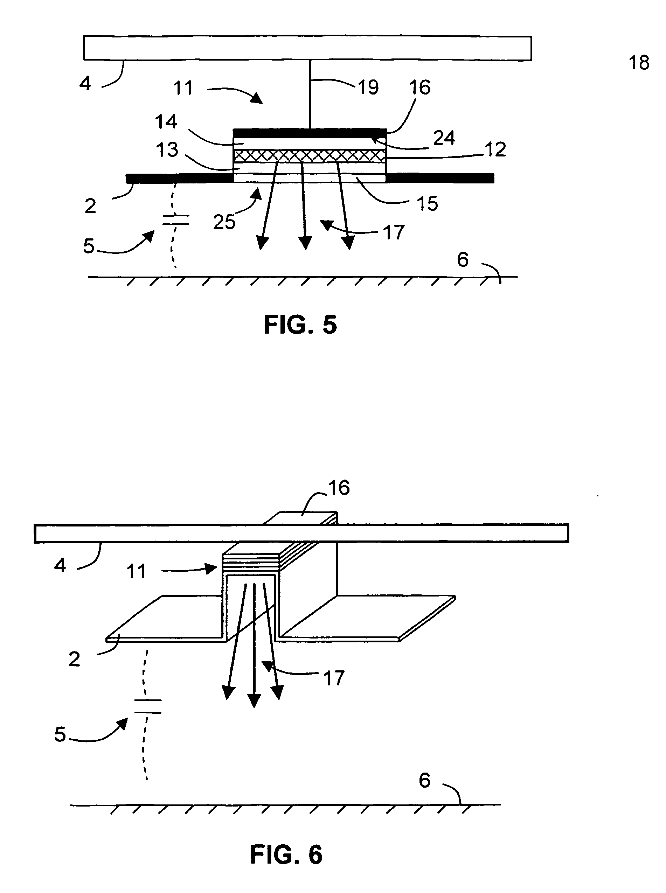

Dans le mode de réalisation de la figure 5, la couche conductrice 16 a une face réfléchissante 24 pour renvoyer vers une direction de visualisation des rayons lumineux émis par la couche électroluminescente. Sur cette figure, le dispositif 11 est disposé sur l'électrode 2 qui présente une ouverture 25 pour le passage du rayonnement lumineux 17. Il est aussi possible de disposer sur l'ouverture 25 un filtre optique pour améliorer le contraste et/ou pour sélectionner une couleur parmi la bande émise par la couche électroluminescente.

La figure 6 montre une disposition particulière d'un dispositif selon un mode de réalisation de l'invention. La couche conductrice 16 est en contact avec un conducteur 4, et l'électrode a une forme déployée éloignée du conducteur se rapprochant de la masse.

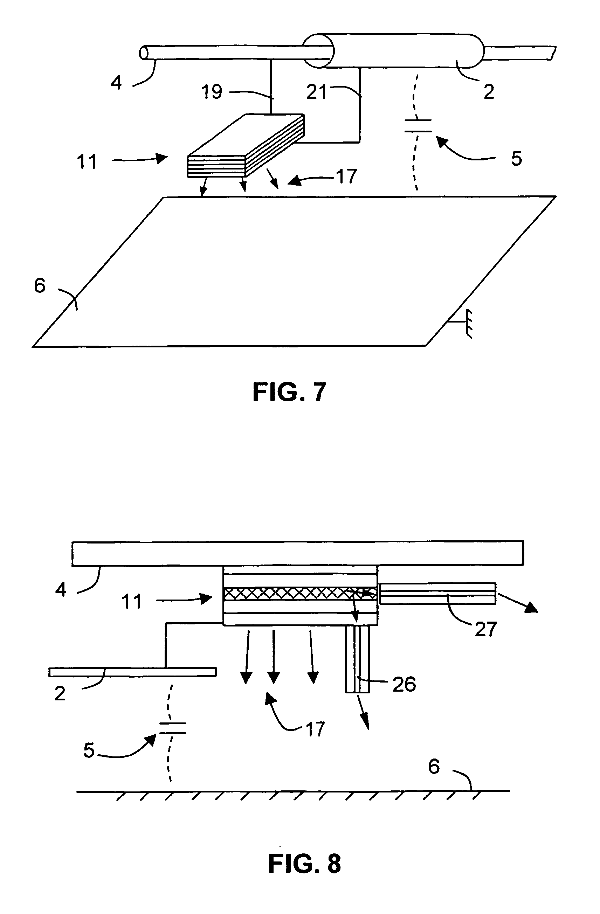

Sur la figure 7, l'électrode 2 collectrice est de forme cylindrique entourant le conducteur 4 et en liaison capacitive 5 avec la masse 6. Le dispositif multicouche 11 a une couche conductrice 16 connectée au conducteur 4 et une couche conductrice 15 connectée à l'électrode 2.

Dans le mode de réalisation de la figure 8, le dispositif multicouche est associé à des conduits optiques 26 ou 27 disposés sur une face ou sur un coté respectivement. Ces conduits permettent de conduire un flux lumineux émis par la couche électroluminescente vers des points de visualisation accessibles ou vers des dispositifs de traitements déportés. Ces conduits peuvent être notamment des fibres optiques ou d'autres conduits en matière appropriée.

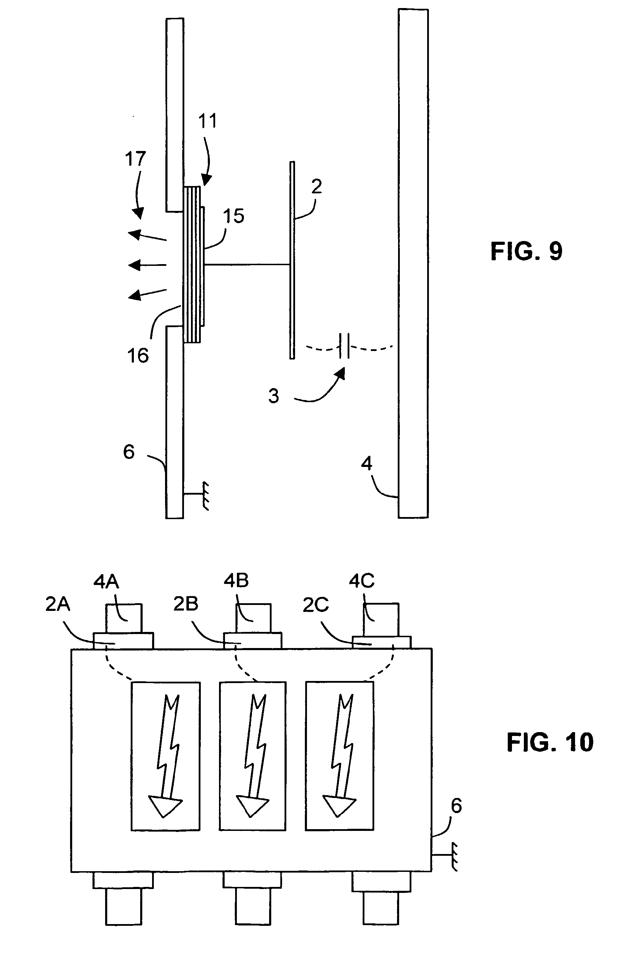

La figure 9 montre un mode réalisation où le dispositif multicouche est au potentiel de la masse 6. La masse 6 peut être notamment une paroi ou une face avant d'un appareil électrique tel qu'une cellule ou une armoire. Dans ce cas, la première couche conductrice 15 est connectée à l'électrode collectrice 2 en liaison capacitive 3 avec le conducteur 4 à surveiller. La seconde électrode conductrice 16 est reliée à la masse 6 et présente une partie translucide pour laisser passer un rayonnement lumineux 17 émis par la couche électroluminescente.

Dans un mode de réalisation où la seconde électrode est reliée à la masse, un dispositif multicouche 11 peut avoir une première couche conductrice en plusieurs parties séparées. Par exemple, pour contrôler trois phases comme le dispositif représenté sur la figure 10. Dans ce dispositif, trois parties séparées d'une première couche conductrice 15 sont connectées à trois électrodes collectrices 2A, 2B, 2C en liaisons capacitives avec trois conducteurs respectivement 4A, 4B et 4C. Sur cette figure, des motifs sont disposés sur des parties visuelles du dispositif. Ces motifs peuvent aussi être visualisés en fonction de la forme des couches conductrices ou électroluminescentes.

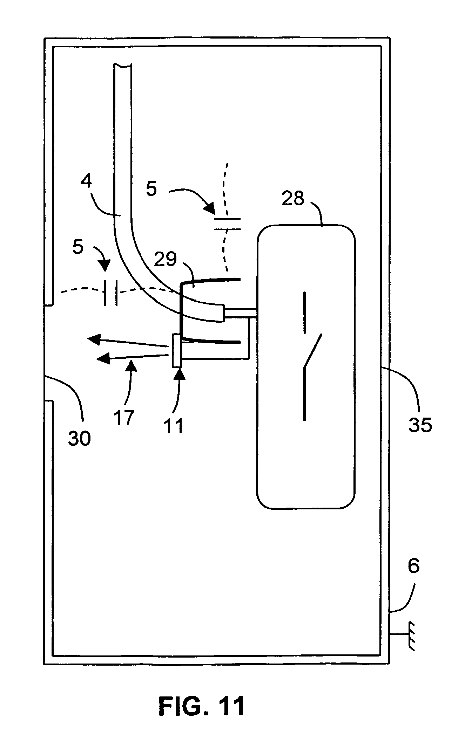

La figure 11 montre un appareil électrique tel qu'une cellule moyenne tension 35 comportant un dispositif selon un mode de réalisation de l'invention. Cet appareil comporte un dispositif de coupure 28, recevant un conducteur électrique 4 et une coupelle 29 de protection du conducteur contre les amorçages électriques en sortie d'un l'isolant dudit conducteur. Dans ce mode de réalisation, la coupelle 29 métallique est avantageusement utilisée aussi comme électrode collectrice. Dans ce mode de réalisation, le dispositif multicouche est disposé à proximité ou sur ladite coupelle. La première électrode conductrice est connectée à la coupelle 28 faisant office d'électrode collectrice, et la seconde électrode conductrice est connectée au conducteur 4 en sortie de son isolant ou sur une borne de sortie sur laquelle le conducteur est connecté. La coupelle est en liaison capacitive 5 avec la masse électrique 6 de la cellule 35. Le rayonnement lumineux est dirigé vers une ouverture de la cellule ou vers une fenêtre de visualisation 30. Un appareil électrique selon l'invention peut aussi être un dispositif de coupure 28 tel qu'un interrupteur ou un disjoncteur comportant un conducteur ou une sortie faisant office de conducteur 4 à surveiller. Dans ce cas, une électrode 2 et un dispositif multicouche 11 peuvent être disposés sur l'appareil.

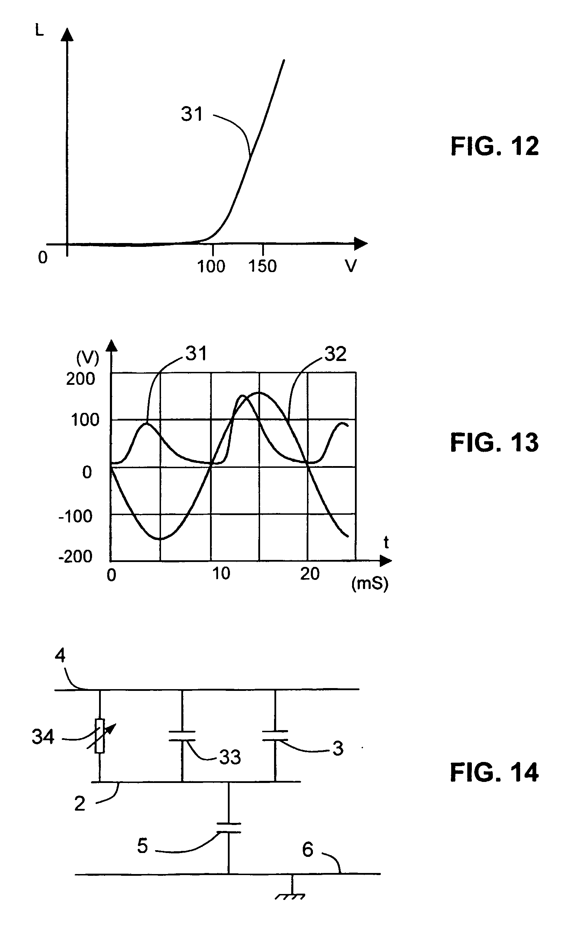

La figure 12 montre un exemple de courbe 31 de luminosité d'un dispositif multicouche. Un seuil de commencement d'éclairement est autour de 100V. Au-delà du seuil, la luminosité est croissante lorsque la tension augmente.

La figure 13 montre un autre exemple de courbe de luminosité d'un dispositif multicouche en tension alternative représentée par une courbe 32.

La figure 14 montre une modélisation électrique d'un dispositif selon un mode réalisation de l'invention. La première liaison capacitive est représentée par un condensateur entre le conducteur 4 est l'électrode collectrice 2, la seconde liaison capacitive est représentée par un condensateur 5 entre l'électrode collectrice 2 et la masse 6. Le dispositif multicouche est représenté par un condensateur 33 représentant les couches conductrices 15 et 16 séparées par des couches isolantes 13 et 14, et par une résistance variable 34 en fonction de la tension représentant le comportement non linéaire de la couche électroluminescente. Dans ce mode de réalisation, le condensateur 33 a une capacité supérieure à celle du condensateur 3, et le condensateur 3 a une capacité supérieure à celle du condensateur 5. Les valeurs des éléments dépendent de la géométrie et des distances entre lesdits éléments.

L'électrode collectrice a de préférence une surface comprise entre 100 et 1000 cm² (centimètres carrés). Lorsque le dispositif multicouche est vers le conducteur 4, la distance entre l'électrode collectrice et la masse peut être, par exemple, entre 10 cm et 1m selon la tension nominale du conducteur à surveiller.

Dans les modes de réalisation décrits ci-dessus les liaisons capacitives avec l'électrode collectrices sont faites entre un conducteur et la masse. Mais il est possible dans d'autres modes de réalisations de l'invention de faire des liaisons capacitives entre deux conducteurs actifs, par exemple pour contrôler la tension entre deux conducteurs de phase.

Les dispositifs selon l'invention sont particulièrement bien adaptés à des tensions alternatives en moyenne tension ou en haute tension. Cependant ils peuvent aussi être utilisés pour d'autres valeurs.

Les dispositifs selon l'invention permettent d'éviter des isolateurs condensateurs pour des liaisons capacitives. Mais ils peuvent aussi être utiliser avec de tels composants tout en restant dans la portée de l'invention, notamment lorsqu'une très forte luminosité est recherchée.

De même, des dispositifs selon l'invention permettent d'éviter des circuits électroniques. Mais des circuits électroniques peuvent aussi être associés à des dispositifs selon l'invention, notamment pour effectuer des fonctions supplémentaires comme par exemple le clignotement du flux lumineux ou le report d'information.

## Revendications

1. Dispositif indicateur de présence tension comportant :
- une électrode (2) collectrice destinée à avoir au moins une liaison capacitive (5) avec une masse électrique (6) ou une liaison capacitive (3) avec un conducteur (4) électrique à surveiller, et
- des moyens (7) de visualisation connectés à ladite électrode collectrice (2) pour indiquer la présence d'une tension électrique dans ledit conducteur électrique à surveiller, le dispositif est **caractérisé en ce que** les moyens de visualisation comportent au moins un dispositif (11) multicouche comportant :
- une couche électroluminescente (12) située entre une première (13) et une seconde (14) couches isolantes,
- une première couche (15) conductrice située sur la première couche isolante (13) et reliée à ladite électrode (2) collectrice, et
- une seconde couche (16) conductrice située sur la seconde couche isolante (14) et reliée audit conducteur (4) électrique à surveiller ou à une masse électrique (6).

2. Dispositif selon la revendication 1 **caractérisé en ce qu'**au moins ladite première couche (15) conductrice ou ladite seconde couche (16) conductrice a au moins une partie (23, 25) transparente ou translucide.

3. Dispositif selon l'une des revendications 1 ou 2 **caractérisé en ce que** ladite couche électroluminescente (12) est réalisée en couche mince d'épaisseur inférieure à 2 µm.

4. Dispositif selon l'une des revendications 1 ou 2 **caractérisé en ce que** ladite couche électroluminescente (12) est réalisée en couche déposée sous forme de poudre.

5. Dispositif selon l'une quelconque des revendications 1 à 4 **caractérisé en ce qu'**au moins ladite première couche (15) conductrice ou ladite seconde couche (16) conductrice a une partie transparente (23) et une partie opaque (22).

6. Dispositif selon l'une quelconque des revendications 1 à 5 **caractérisé en ce qu'**au moins ladite première couche (15) conductrice ou ladite seconde couche (16) conductrice comporte une face (24) réfléchissante dirigée vers la couche (12) électroluminescente.

7. Dispositif selon l'une quelconque des revendications 1 à 6 **caractérisé en ce que** l'électrode collectrice (2) et ladite première couche (15) conductrice forment un même élément

8. Dispositif selon l'une quelconque des revendications 1 à 7 **caractérisé en ce que** les couches (15, 16, 13, 14, 12) conductrices, isolantes, et électroluminescente sont disposées sur un substrat (18) en verre et protégées par un recouvrement (20) protecteur.

9. Dispositif selon l'une quelconque des revendications 1 à 8 **caractérisé en ce que** l'électrode collectrice (2) à une forme sensiblement cylindrique et est située autour du conducteur (4) électrique à surveiller.

10. Dispositif selon l'une quelconque des revendications 1 à 9 **caractérisé en ce que** le dispositif (11) multicouche est situé sur le conducteur (4) électrique à surveiller, la seconde couche conductrice (16) étant en contact avec ledit conducteur électrique à surveiller.

11. Dispositif selon l'une quelconque des revendications 1 à 10 **caractérisé en ce que** l'électrode électroluminescente (2) a une surface inférieure à 1 cm² et l'électrode collectrice (2) à une surface comprise entre 100 et 1000 cm².

12. Dispositif selon l'une quelconque des revendications 1 à 11 **caractérisé en ce que** l'électrode collectrice (2) est formée par une coupelle (29) de protection d'un conducteur (4) électrique à surveiller d'un appareil haute ou moyenne tension, les moyens de visualisation (7, 11) étant disposés à proximité ou sur ladite coupelle de protection.

13. Appareil électrique comportant au moins un conducteur électrique (4) **caractérisé en ce qu'**il comporte un dispositif indicateur de présence tension selon l'une des revendications 1 à 12 pour indiquer la présence de tension électrique sur ledit au moins un conducteur (4) électrique à surveiller.

14. Appareil électrique selon la revendication 13 **caractérisée en ce qu'**il est constitué par une cellule (35) moyenne tension ou haute tension.

15. Appareil électrique selon la revendication 14 **caractérisée en ce que** la forme de électrode collectrice (2) et sa distance par rapport audit conducteur électrique à surveiller (4) ou à ladite masse électrique (6) sont déterminées pour avoir un seuil d'éclairage de la couche luminescente (12) à partir d'une tension électrique, entre ledit conducteur électrique à surveiller et ladite masse, supérieure à 3000 V.

## Claims

1. Voltage presence indicator device comprising:
- a collector electrode (2) designed to have at least one capacitive connection (5) with an electrical ground (6) or a capacitive connection (3) with an electrical conductor (4) to be monitored, and
- display means (7) connected to said collector electrode (2) to indicate the presence of an electrical voltage in said electrical conductor to be monitored, device is **characterized in that** the display means comprise at least one multilayer device (11) comprising:
- a light-emitting layer (12) arranged between a first insulating layer (13) and a second insulating layer (14),
- a first conducting layer (15) arranged on the first insulating layer (13) and connected to said collector electrode (2), and
- a second conducting layer (16) located on the second insulating layer (14) and connected to said electrical conductor (4) to be monitored or to an electrical ground (6).

2. Device according to claim 1 **characterized in that** at least said first conducting layer (15) or said second conducting layer (16) has at least one transparent or translucent part (23, 25).

3. Device according to one of claims 1 or 2 **characterized in that** said light-emitting layer (12) is achieved as a thin film with a thickness of less than 2 µm.

4. Device according to one of claims 1 or 2 **characterized in that** said light-emitting layer (12) is achieved as a layer deposited in powder form.

5. Device according to any one of claims 1 to 4 **characterized in that** at least said first conducting layer (15) or said second conducting layer (16) has a transparent part (23) and an opaque part (22).

6. Device according to any one of claims 1 to 5 **characterized in that** at least said first conducting layer (15) or said second conducting layer (16) comprises a reflecting face (24) directed towards the light-emitting layer (12).

7. Device according to any one of claims 1 to 6 **characterized in that** the collector electrode (2) and said first conducting layer (15) form a single element.

8. Device according to any one of claims 1 to 7 **characterized in that** the conducting, insulating, and light-emitting layers (15, 16, 13, 14, 12) are arranged on a glass substrate (18) and protected by a protective covering (20).

9. Device according to any one of claims 1 to 8 **characterized in that** the collector electrode (2) has a substantially cylindrical shape and is located around the electrical conductor (4) to be monitored.

10. Device according to any one of claims 1 to 9 **characterized in that** the multilayer device (11) is located on the electrical conductor (4) to be monitored, the second conducting layer (16) being in contact with said electrical conductor to be monitored.

11. Device according to any one of claims 1 to 10 **characterized in that** the light-emitting electrode (2) has a surface smaller than 1 cm² and the collector electrode (2) has a surface comprised between 100 and 1000 cm².

12. Device according to any one of claims 1 to 11 **characterized in that** the collector electrode (2) is formed by a protective cap (29) of an electrical conductor (4) to be monitored of a high or medium voltage apparatus, the display means (7, 11) being arranged near to or on said protective cap.

13. Electrical apparatus comprising at least one electrical conductor (4) **characterized in that** it comprises a voltage presence indicator device according to one of claims 1 to 12 to indicate the presence of electrical voltage on said at least one electrical conductor (4) to be monitored.

14. Electrical apparatus according to claim 13 **characterized in that** it is formed by a medium-voltage or high-voltage cubicle (35).

15. Electrical apparatus according to claim 14 **characterized in that** the shape of the collector electrode (2) and its distance with respect to said electrical conductor (4) to be monitored or to said electrical ground (6) are determined so as to have a lighting threshold of the light-emitting layer (12), from an electrical voltage between said electrical conductor to be monitored and said ground, of more than 3000 V.

## Patentansprüche

1. Spannungsmeldeeinrichtung mit
- einer Sammelelektrode (2), die mindestens eine kapazitive Verbindung (5) mit einer elektrischen Masse (6) oder eine kapazitive Verbindung (3) mit einem zu überwachenden elektrischen Leiter (4) aufweist,
- sowie an die genannte Sammelelektrode (2) angeschlossenen Anzeigemitteln (7) zur Anzeige des Vorhandenseins einer elektrischen Spannung im genannten, zu überwachenden elektrischen Leiter,
welche Einrichtung **dadurch gekennzeichnet ist, dass** die Anzeigemittel mindestens ein Mehrschichtelement (11) umfassen, das
- eine zwischen einer ersten Isolierschicht (13) und einer zweiten Isolierschicht (14) angeordnete Leuchtschicht (12),
- eine auf der ersten Isolierschicht (13) angeordnete und mit der genannten Sammelelektrode (2) verbundene erste leitende Schicht (15)
- sowie eine auf der zweiten Isolierschicht (14) angeordnete und mit dem genannten, zu überwachenden elektrischen Leiter (4) oder einer elektrischen Masse (6) verbundene zweite leitende Schicht (16) umfasst.

2. Einrichtung nach Anspruch 1, **dadurch gekennzeichnet, dass** mindestens die genannte erste leitende Schicht (15) oder die genannte zweite leitende Schicht (16) mindestens einen durchsichtigen oder durchscheinenden Bereich (23, 25) umfassen.

3. Einrichtung nach einem der Ansprüche 1 oder 2, **dadurch gekennzeichnet, dass** die genannte Leuchtschicht (12) als Dünnschicht mit einer Dicke unter 2 µm ausgebildet ist.

4. Einrichtung nach einem der Ansprüche 1 oder 2, **dadurch gekennzeichnet, dass** die genannte Leuchtschicht (12) als durch Pulverauftrag gebildete Schicht ausgebildet ist.

5. Einrichtung nach irgendeinem der Ansprüche 1 bis 4, **dadurch gekennzeichnet, dass** mindestens die genannte erste leitende Schicht (15) oder die genannte zweite leitende Schicht (16) einen durchsichtigen Bereich (23) und einen undurchsichtigen Bereich (22) umfasst.

6. Einrichtung nach irgendeinem der Ansprüche 1 bis 5, **dadurch gekennzeichnet, dass** mindestens die genannte erste leitende Schicht (15) oder die genannte zweite leitende Schicht (16) eine der Leuchtschicht (12) zugewandte reflektierende Seite (24) umfassen.

7. Einrichtung nach irgendeinem der Ansprüche 1 bis 6, **dadurch gekennzeichnet, dass** die Sammelelektrode (2) und die genannte erste leitende Schicht (15) als ein Teil ausgebildet sind.

8. Einrichtung nach irgendeinem der Ansprüche 1 bis 7, **dadurch gekennzeichnet, dass** die leitenden Schichten, die Isolierschichten und die Leuchtschicht (15, 16, 13, 14, 12) auf einem Glassubstrat (18) angeordnet und durch eine Schutzabdeckung (20) geschützt sind.

9. Einrichtung nach irgendeinem der Ansprüche 1 bis 8, **dadurch gekennzeichnet, dass** die Sammelelektrode (2) annähernd zylindrisch ausgebildet und um den zu überwachenden elektrischen Leiter(4) herum angeordnet ist.

10. Einrichtung nach irgendeinem der Ansprüche 1 bis 9, **dadurch gekennzeichnet, dass** das Mehrschichtelement (11) auf dem zu überwachenden elektrischen Leiter (4) angeordnet ist, wobei sich die zweite leitende Schicht (16) und der genannte, zu überwachende elektrische Leiter berühren.

11. Einrichtung nach irgendeinem der Ansprüche 1 bis 10, **dadurch gekennzeichnet, dass** die Leuchtschicht (12) eine Oberfläche von unter 1 cm² und die Sammelelektrode (2) eine Oberfläche zwischen 100 und 1000 cm² aufweist.

12. Einrichtung nach irgendeinem der Ansprüche 1 bis 11, **dadurch gekennzeichnet, dass** die Sammelelektrode (2) durch eine Schutzkappe (29) eines zu überwachenden elektrischen Leiters (4) eines Hoch- oder Mittelspannungs-Schaltgeräts gebildet wird, wobei die Anzeigemittel (7, 11) in der Nähe oder auf der genannten Schutzkappe angeordnet sind.

13. Elektrisches Schaltgerät mit mindestens einem elektrischen Leiter (4), **dadurch gekennzeichnet, dass** es eine Spannungsmeldeeinrichtung nach einem der Ansprüche 1 bis 12 zur Anzeige des Vorhandenseins einer elektrischen Spannung an dem genannten, mindestens einen zu überwachenden elektrischen Leiter (4) umfasst.

14. Elektrisches Schaltgerät nach Anspruch 13, **dadurch gekennzeichnet, dass** es aus einer Mittelspannungs- oder Hochspannungs-Schaltzelle (35) besteht.

15. Elektrisches Schaltgerät nach Anspruch 14, **dadurch gekennzeichnet, dass** die Form der Sammelelektrode (2) sowie ihr Abstand zum genannten, zu überwachenden elektrischen Leiter (4) oder zur genannten elektrischen Masse (6) so ausgelegt sind, dass sich ein Leuchtschwellwert der Leuchtschicht (12) in Abhängigkeit von einer elektrischen Spannung über 3000 V zwischen dem genannten elektrischen Leiter und der genannten Masse ergibt.
